# EUROPEAN PATENT SPECIFICATION

(11) **EP 0 774 837 B1**
(45) Date of publication and mention of the grant of the patent: **02.02.2000**
(21) Application number: 95308151.0
(22) Date of filing: 14.11.1995
(51) Int. Cl.: H03K 17/95

(54) **Condition responsive solid-state switch**
Zustandsabhängiger Festkörperschalter
Commutateur solide repondant à une condition

(43) Date of publication of application: 21.05.1997
(73) Proprietor: Eldec Corporation, Lynnwood Washington 98046-0100 (US)
(72) Inventor: Cederlind, Gregory F., Woodinville, Washington 98072 (US)
(74) Representative: Spall, Christopher John

(56) References cited:
- EP-A- 0 620 647
- DE-C- 3 828 428
- US-A- 5 345 166
- US-A- 5 412 255

## Description

### Field of the Invention

The present invention relates to a solid-state switch that responds automatically to change in an environmental condition to which the switch is subjected, and particularly to such a switch which will emulate operation of a mechanical switch for retrofit into existing installations or circuit designs.

### Background of the Invention

There are known mechanical switches that respond to changes in the switch environment, in fact such condition responsive mechanical switches are in wide use. An example is a pressure responsive switch, and a representative application is a pressure responsive switch associated with an aircraft turbine engine. For maximum fuel efficiency, the flow of coolant may be adjusted based on absolute pressure, such as by a solenoid valve controlled by a pressure responsive mechanical switch. Mechanical pressure switches can directly switch electrical leads using only two wires by being connected in series between a power source and the load. Improvements have been made to increase the useful life of mechanical switches, such as the use of sealed contacts. Nevertheless, contact fretting, wear, fatigue, and arcing in harsh environments have continued to be problems. In addition, in the case of a short circuit in the line closed by the switch, no effective current limit is provided.

Solid-state switches have no wearout or cycle life within the rated usage. However, for a system built or designed for use of a mechanical switch, substitution of a solid-state switch may not be possible without extensive redesign. In some fields such redesign can greatly increase the expense, such as in the aircraft industry where significant redesign of circuitry associated with an aircraft engine may require recertification. Such redesign could involve adding a third wire from airframe power to provide a continuous power supply current path for the electronic circuit of the solid-state switch. By comparison, mechanical switches typically require no external power.

Alternatively, the solid-state switch could be designed to have a continuous voltage drop across the switch sufficient to operate its own electronic circuitry. Nevertheless, the voltage drop would subtract from the supply voltage and thereby cause operational problems at low-voltage conditions. In addition, the several volt drop across the switch required to operate its internal circuitry, combined with a large load current, could result in several watts of power dissipation, which further complicates the situation because of excessive switch heating. In an aircraft turbine engine environment, heat already may be a problem given the extreme temperatures to which the switch is subjected.

US-A 5 412 255 discloses a switch device for use in automobile vehicles in which an electric circuit connected across the terminals of the switch derives power from the line and uses that power to control the switch in response to environmental parameters. However, this switch arrangement has an effect of the power supply to the load in the switch off condition which is unacceptable under many conditions.

### Summary of the Invention

The present invention provides an automatic condition responsive solid-state switch that emulates a mechanical switch by requiring only two-wire electrical connection, i.e., connection between a power source and a load, and which does not require additional external power, and which does not significantly affect power supply to the load. In the preferred embodiment, the switch in accordance with the present invention is responsive to changes in absolute pressure and operates reliably with predetermined hysteresis over a wide temperature range and for a wide range of supplied voltage.

In accordance with a first aspect the invention provides a switch having two switching terminals for automatically controlling the supply of power from a voltage source (V+), connected to one of said terminals, to a load, connected to the other of said terminals, based on an environmental condition to which the switch is subjected comprising:
a solid-state switching component coupled between said two terminals which are connectable respectively to the voltage source (V+) and the load and having a trigger input for actuation of the switching component so as to selectively control the switching component between an on state and an off state;
an off timer circuit powered by the voltage source (V+), through a coupling to said two terminals only, when the switching component is in its off state for periodically generating pulses of short duration with the period between consecutive pulses being much greater than the duration of each pulse;
a sensing circuit for sensing the environmental condition and for generating a trigger signal pulse to the trigger input of the switching component based on the condition sensed, such that the switching component is actuated to its on and off states as a function of changes in the sensed condition; and
an on-timer circuit powered by the voltage source (V+), through a coupling to said two terminals only, when the switching component is in its on state for periodically momentarily supplying an interrupt signal to the trigger input of the switching component to actuate the switching component to its off state if the switching component was previously in its on state for powering the off timer circuit to again supply the power pulses, whereby the environmental condition continues to be sensed periodically and the trigger signal continues to be generated periodically based on the sensed condition;
characterized by:
the pulses generated by the off timer circuit being power pulses; and
the sensing circuit being powered by the power pulses for sensing the environmental condition only during each power pulse, and for generating the trigger signal for each power pulse for application to the trigger input of the switching component based on the condition sensed.

In accordance with a second aspect, the invention provides the method of automatically controlling the supply of power from a voltage source (V+) and the load, such switching component having a trigger input for actuation between an on state and off state; an off timer circuit and an on-timer circuit being powered by said voltage source through a coupling to the terminals of the switching component only
characterized by:
when the switching component is off, periodically applying by said off timer circuit a power pulse of short duration with the period between consecutive power pulses being much greater than the duration of each pulse to a sensing circuit for sensing the environmental condition only during each power pulse, such sensing circuit including means for generating a trigger signal to the switching component such that the switching component is actuated to its on and off states as a function of change if the sensed condition; and
when the switching component is on, periodically momentarily actuating the switching component to its off condition by said on-timer circuit for again supplying the periodic power pulses for monitoring the sensed condition.

The switch in accordance with the present invention uses pulse techniques for periodically monitoring the desired condition, such as pressure. In the off state, power from the source drives a timer circuit which supplies a short voltage pulse to the condition sensing circuitry, and to associated circuitry for temperature compensation, amplification of the resulting pressure signal, and a comparator circuit which determines whether or not the pressure indicated by the amplified pressure signal exceeds a predetermined pressure threshold. If the sensed pressure is greater than the predetermined pressure, a power switch (power transistor) is turned on to connect the voltage source to the load. Turning on or closing the power switch results in substantially eliminating the voltage drop between the switch terminals, which previously was used to actuate the timer circuit. Accordingly, a separate timer circuit is provided to periodically open the closed power switch for again evaluating the sensed condition and, if appropriate, turning the power switch off.

Associated circuitry controls the circuit hysteresis to prevent undesirable chattering when the pressure stays close to the threshold pressure. Predetermined limits are established such that the power switch remains in its on or off state for a range of pressures which depend on whether the switch previously was open or closed. The switch also can include circuitry for limiting the maximum current conveyed through the switch and for providing a trickle current bypassing the switch when it is open for a standard circuit integrity check.

### Brief Description of the Drawings

The foregoing aspects and many of the attendant advantages of this invention will become more readily appreciated as the same becomes better understood by reference to the following detailed description, when taken in conjunction with the accompanying drawings, wherein:

FIGURE 1 is a diagrammatic illustration of a conventional mechanical pressure responsive switch.

FIGURE 2 is a block diagram of a condition responsive solid state-switch in accordance with the present invention.

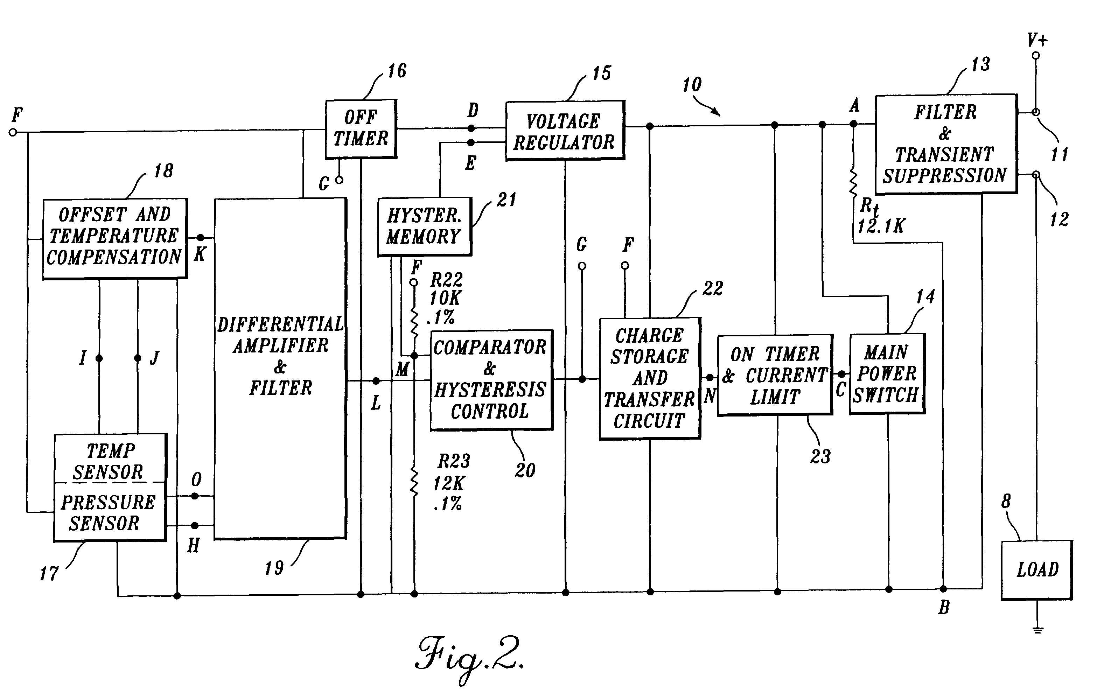

Each of FIGURES 2-8 is a detailed circuit diagram of a component of the circuit of FIGURE 2.

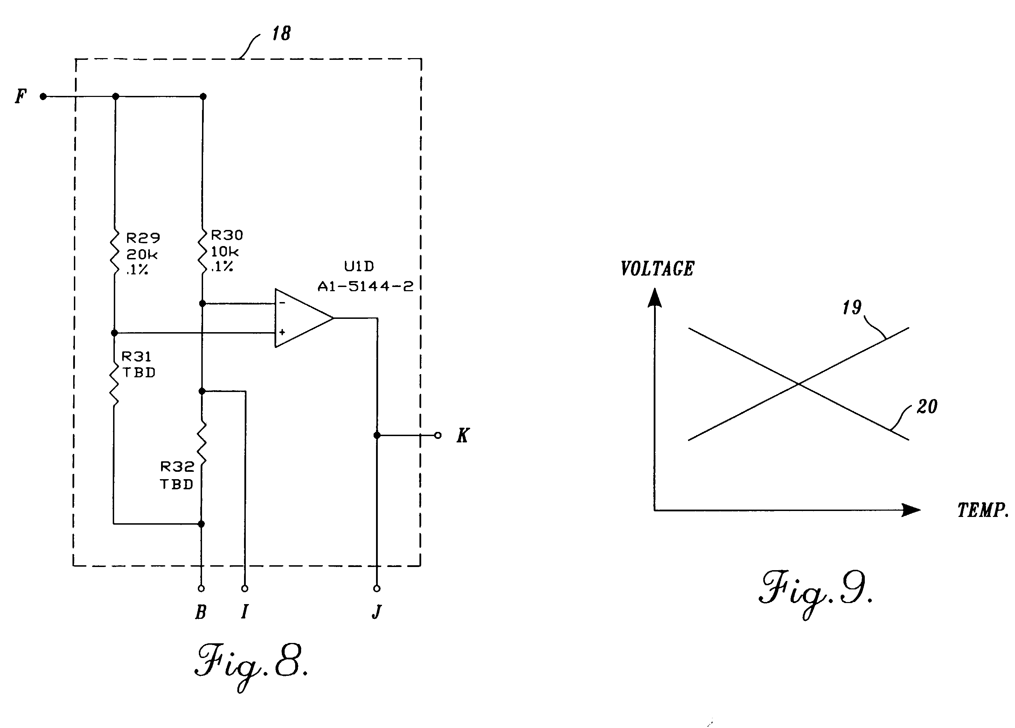

FIGURE 9 is graph illustrating operation of a component of the circuit in accordance with the present invention, namely, temperature compensation.

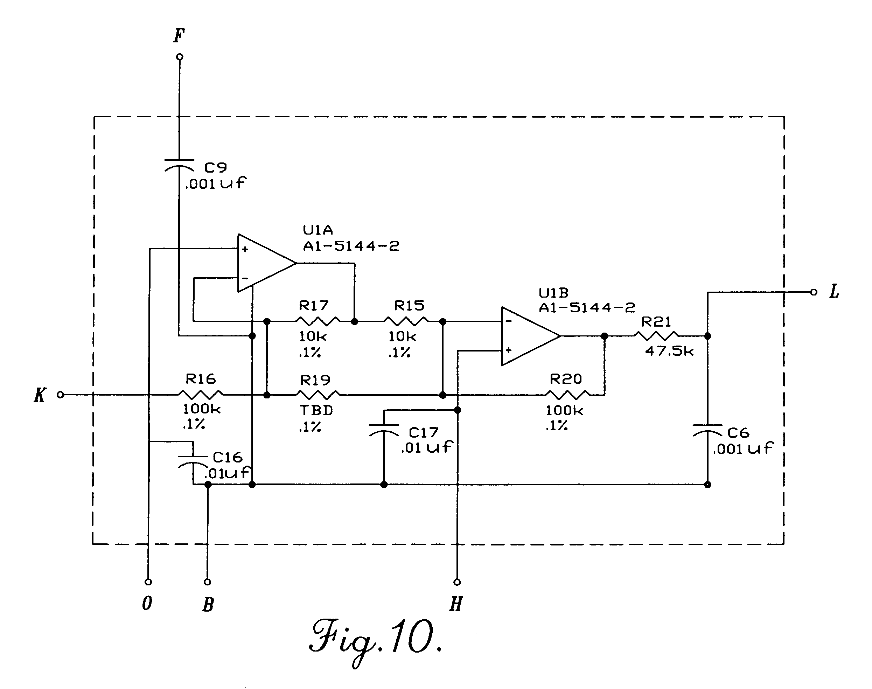

Each of FIGURES 10-14 is a detailed circuit diagram of a component of the circuit of FIGURE 2.

### Detailed Description of the Preferred Embodiment

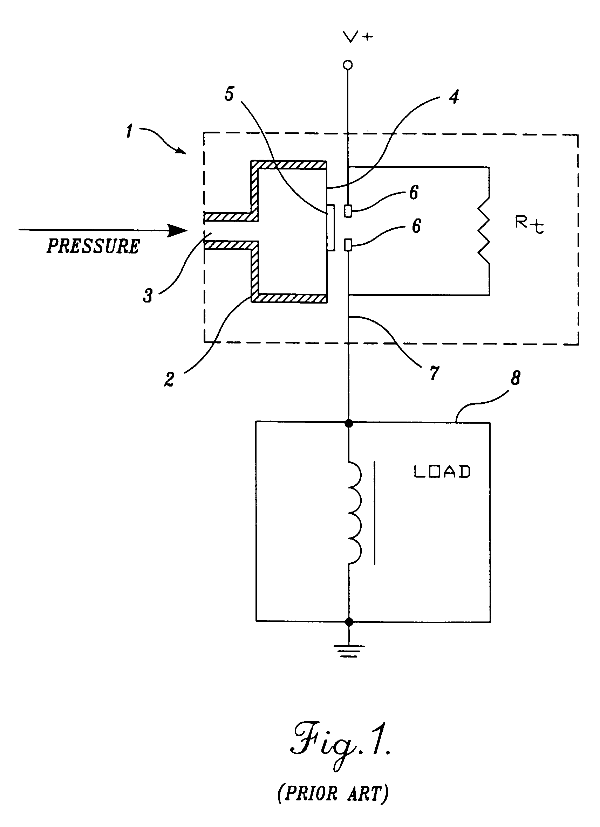

FIGURE 1 illustrates diagrammatically a conventional mechanical switch automatically responsive to an environmental condition to which the switch is subjected, namely, pressure. The conventional switch 1 can include a housing 2 having an orifice 3 such that the interior of the housing is exposed to surrounding atmosphere. Housing 2 supports a movable diaphragm 4 having a central electrically conductive contact 5. For pressure exceeding a predetermined pressure, the diaphragm moves to engage its contact 5 against conductive terminals 6 in the line 7 between a voltage source (V+) and a load 8. In addition, known mechanical pressure switches may be provided with a resistor Rₜ connected across the contacts 6 so that a conventional line integrity check can be made even when the switch is open. For example, such an integrity check may be desirable to confirm that the load has not been short-circuited, which could not be determined upstream from the switch with the switch open unless there is some parallel current path across the contacts 6.

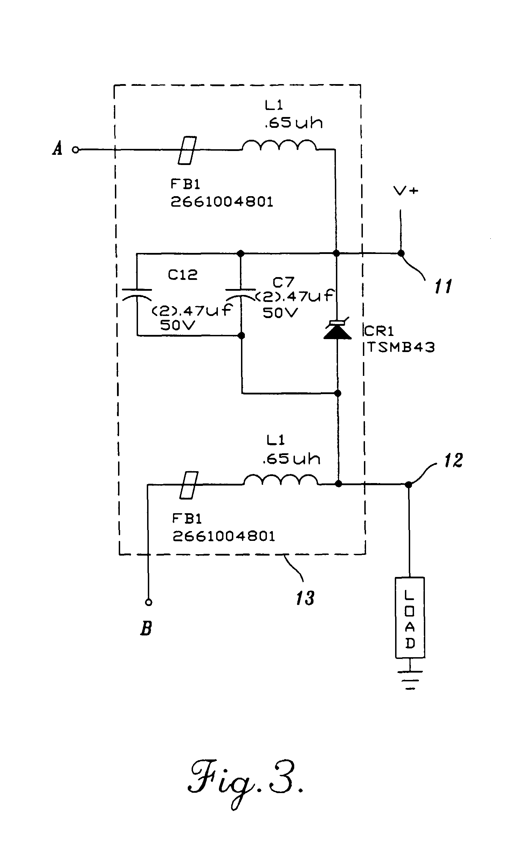

With reference to FIGURE 2, the switch circuit 10 in accordance with the present invention provides the advantages of solid-state operation, which include advanced temperature compensation, hysteresis, current limit, reliability and long life, without requiring an independent power source or line, and without significantly affecting voltage supplied to the load. Rather, switch circuit 10 is simply connected between line terminals 11 and 12 between the voltage source (V+) and the load 8. Consequently, switch 10 can be substituted for known mechanical switches in existing designs, and even be retrofitted into existing installations. The particular application for the preferred embodiment in accordance with the present invention is in an aircraft turbine engine environment. To illustrate the complexity of the specifications that must be met, the preferred embodiment described below meets the following design criteria:
Trigger point: at falling pressure, switch to close at 70 PSIA ± 3 PSIA;
Hysteresis: switch to open at 7.5 PSIA above the actual switch point, ± 2.5 PSIA;
Temperature: switch to operate reliably through a temperature range of -65°F to positive 300°F;
Power requirement: switch to operate for standard airframe power, varying from 16 volts DC to 32 volts DC (as compared to nominal air frame power of 28 volts DC);
Load: switch effective to drive a load (solenoid valve) of about 240 millihenries and 40 ohms, maximum current 1 amp.
In general, the representative and preferred embodiment circuit of the switch in accordance with the present invention is shown in block diagram form in FIGURE 2, and the detailed circuit diagrams are shown in FIGURES 3-8 and 10-14. Reference letters A through O indicate the points of interconnection of the different circuit components. Beginning at the line terminals 11 and 12 between the power source (V+, e.g., standard airframe power) and load 8, the initial component is a filter and transient suppression circuit 13, shown in detail in FIGURE 3, which filters the airframe 28 volt DC power (variable from 16 volts to 32 volts) through a network of inductors, capacitors, and ferrite beads. These filter components help assure compliance with electromagnetic interference specifications. Input voltage transients are suppressed though a fast-action zener diode CR1 connected across the input.

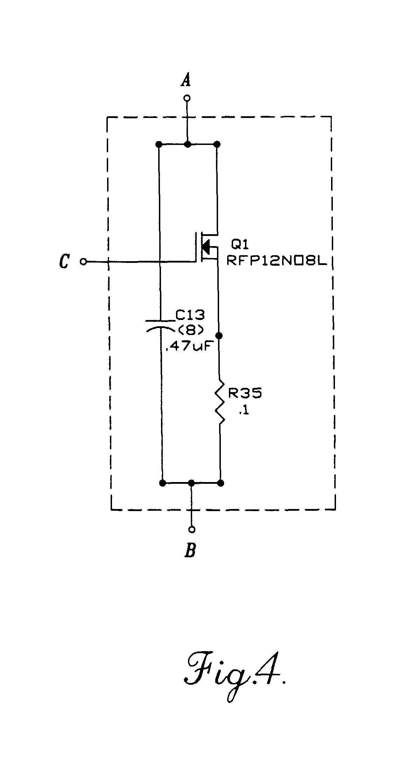

Returning to FIGURE 2, the heart of the circuit in accordance with the present invention is the main power switch 14, for which the detailed circuit is shown in FIGURE 4. Such switch consists of a power MOSFET Q1 which, based on a charging or discharging signal supplied at connection C, is maintained in its on (closed) state or its off (open) state. Capacitor C13 dampens the flyback or ringing from an inductive load whenever Q1 opens. R35 helps limit peak current through Q1 by providing a voltage drop that subtracts from the gate drive voltage. With Q1 "off" (main power switch opened), there would be an essentially open circuit between switch terminals 11 and 12 shown in FIGURE 2, except for resistor Rₜ which functions to provide a trickle current for standard line integrity checks. In addition, in this condition there is substantial voltage potential between points A and B usable to power the remainder of the circuit.

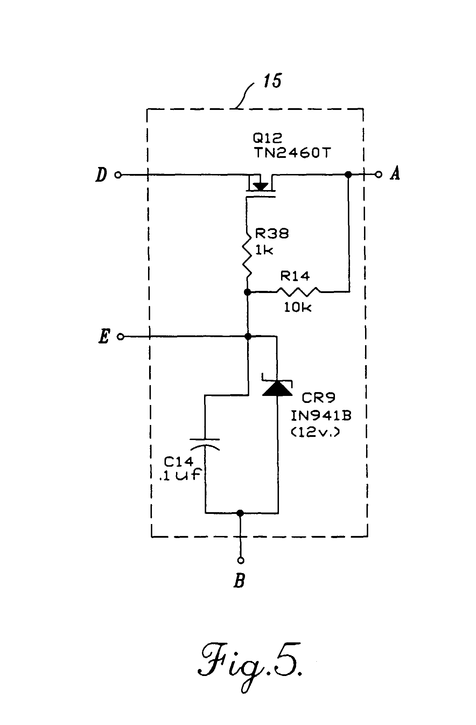

Continuing with the main power switch 14 in its open or off condition, the next circuit component is a voltage regulator 15 for which the detailed circuit diagram is shown in FIGURE 5. Unregulated air frame provided DC power is regulated by a zener diode CR9 and buffered by a source follower to provide an output of about 10 volts DC at output D. The regulated DC voltage output at point E is about 12 volts.

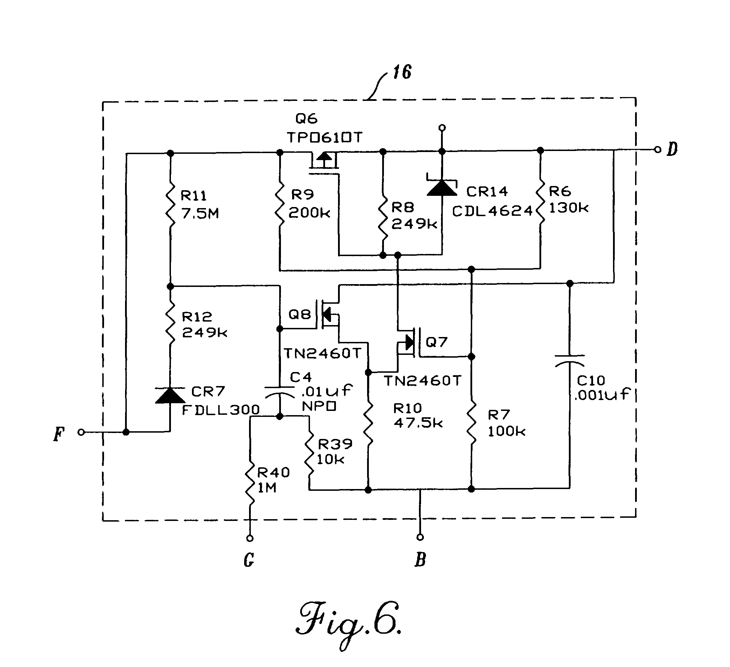

As seen in FIGURE 2, the 10-volt DC output (D) of the voltage regulator is supplied to a timer circuit 16, referred to as the "off timer" because it operates when the main power switch 14 is off or opened. As seen in FIGURE 6, the off timer 16 is an astable multivibrator providing output voltage pulses that power several circuit components, described in more detail below. In the preferred embodiment, the output pulses supplied at point F have a duration of about 1 millisecond, with a period of about 32 milliseconds between consecutive pulses, and a pulse height of about 10 volts. Consequently, the off timer substantially reduces average current drain for the condition when the main power switch is off.

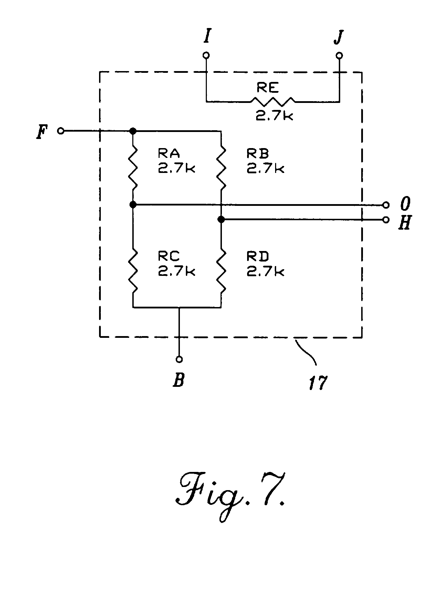

Output pulses from the off timer are supplied to a combined temperature sensing and pressure sensing circuit 17 shown in FIGURE 7. For pressure sensing, silicon piezoresistive strain sensing resistors RA, RB, RC and RD are arranged in a bridge configuration on a pressure sensing diaphragm. The bridge differential output voltage across points O and H varies in proportion to pressure when excited with a constant voltage source, such as a 1 millisecond 10-volt pulse from the off timer (point F). The temperature sensing resistor RE varies proportional to temperature. The preferred pressure sensing and temperature sensing circuit is a silicon on sapphire bridge pressure sensor with an integral temperature sensing resistor.

The pulse output of the off timer also is supplied to an offset and temperature compensation circuit 18, shown in detail in FIGURE 8. Solid-state pressure sensors provide a consistent voltage output, but are not perfect in providing outputs identical for different sensors. Each individual pressure sensor voltage output varies as a function of temperature. In addition, zero pressure does not necessarily result in zero output volts. In the temperature compensation and offset circuit, a pair of voltage dividers is set up such that the difference between them compensates for the pressure sensor offset. Further, the divider resistances are calculated such that, in combination with the integral temperature sensor changing resistance, the compensation offset voltage varies appropriately with temperature to compensate for the pressure sensor voltage output that changes as a function of temperature. Values for resistors R31 and R32 must be selected judiciously after testing the pressure-temperature sensor to determine its individual characteristics. In a representative embodiment, R31 may be 6.8 K ohms and R32 may be 2.2 K ohms. The desired relationship of varying pressure voltage output and the output of the temperature compensation circuit is illustrated in FIGURE 9. Line 19 represents pressure signal variation as a function of temperature, whereas line 20 represents the voltage output (point K) of the offset and temperature compensation circuit 18. Preferably, the two lines have slopes of equal but opposite magnitudes such that, downstream, variation of the voltage of the pressure signal as a function of temperature is compensated for by the signal from the offset and temperature compensation circuit 18.

The voltage pulses from the off timer (F) also are used to power the differential amplifier circuit 19 shown in detail in FIGURE 10. The voltage gain is adjusted by selection of resistor R19, based on the characteristics of the individual sensor used. In a representative embodiment, the value of R19 can be 6.9 K ohms. The amplifier circuit includes a low pass filter, R21 and C6, to reduce transients caused by the pulsed power application.

Returning to FIGURE 2, the output from the amplifier and filter circuit 19 (point L) is proportional to pressure and reliable for the desired temperature range. Such output serves as one input to a comparator and hysteresis control circuit 20. The other input, point M, is a reference voltage derived by applying the off timer pulse output (F) across a voltage divider consisting of resistor R22 and resistor R23.

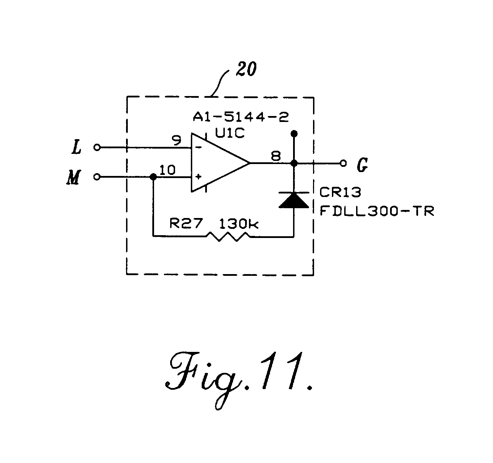

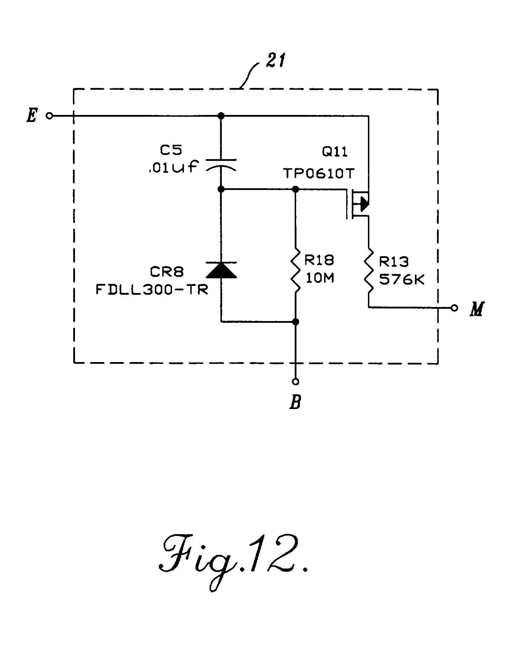

The detailed circuit of the comparator 20 is shown in FIGURE 11. The comparator supplies an output (point G) if the pressure signal (L) exceeds the reference voltage (M), with the desired hysteresis by virtue of the feedback loop consisting of R27 and CR13. However, the switch point is adjusted based on whether the main power switch was turned on or off during the last cycle, i.e., during the evaluation or monitoring period of the previous pulse supplied by the off timer. This adjustment is accomplished by the hysteresis memory circuit 21 shown in FIGURE 12. Power to the hysteresis memory circuit comes directly from the voltage regulator's zener diode (point E) to minimize interaction with other circuit components. Depending on whether the switch previously was on, the effect of the hysteresis memory circuit is to adjust the reference voltage at point M. Recall, for example, that the design criteria requires initial switchover at decreasing pressure of 70 PSIA (± 3 PSIA) with hysteresis of 7.5 PSIA from the actual switch point (± 3 PSIA). If the power switch is open, regulated power at point E charges capacitor C5 sufficiently to turn on transistor Q11 which adjusts the reference voltage at point M. If the power switch is closed, there is insufficient voltage to operate the voltage regulator and transistor Q11 remains off. As described in more detail below, the closed power switch is opened for short periods during circuit operation, but the duration is not long enough to charge C5 sufficiently to actuate transistor Q11. Consequently, Q11 is turned on only when the power switch is off, which has the effect of adjusting the reference voltage at point M.

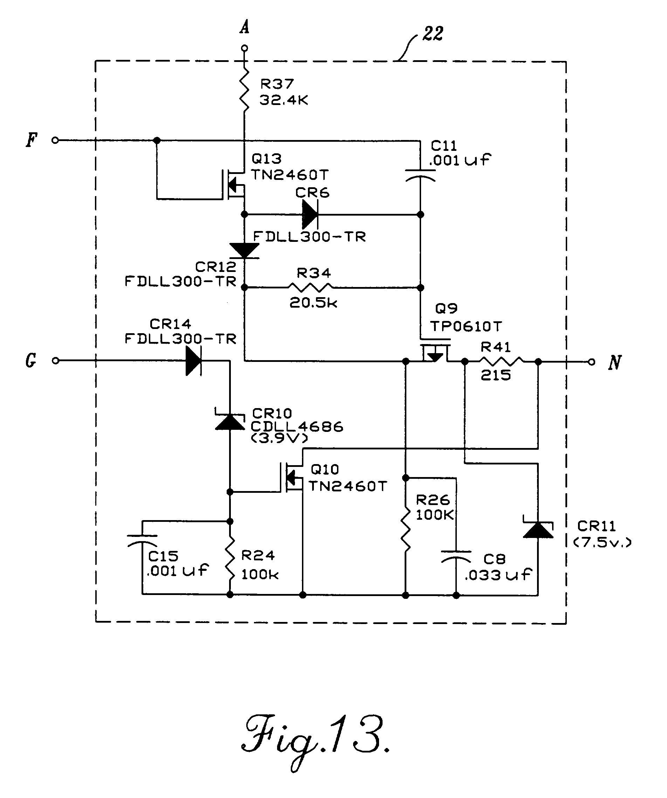

Ultimately, a signal from the comparator circuit 20 (G) is conveyed to a charge storage and transfer circuit 22 for triggering the main power switch to close. Circuit 22 is shown in detail in FIGURE 13. Power to such circuit also is supplied by the output pulse (F) of the off timer. At startup, a capacitor, C8, is charged. When the sensed pressure is above the established threshold level (appropriate hysteresis being considered), the signal from comparator (G) will, at the falling edge of the power pulse (F), result in transferring the charge from capacitor C8 to the output line N. The charge storage and transfer circuit is tuned such that the amount of charge is sufficient to turn the main power switch on for expected load currents, but will desaturate readily for overload conditions. This is accomplished by selection of the values for R26 and C8. More specifically, a high voltage signal at G results in turning transistor Q10 on which results in essentially a short circuit between N and B. In this condition, the charge stored in capacitor C8 is not transferred. A low voltage signal at G results in Q10 remaining off. In this condition, the gate of transistor Q9 is driven at the falling edge of a power pulse (F) from the off timer, such that charge stored in capacitor C8 is transferred to point N through Q9 and R41. In general, R37, Q13 and CR12 are in the precharge path for capacitor C8, whereas CR6, R34 and C11 cooperate to drive Q9 at the falling edge of a power pulse.

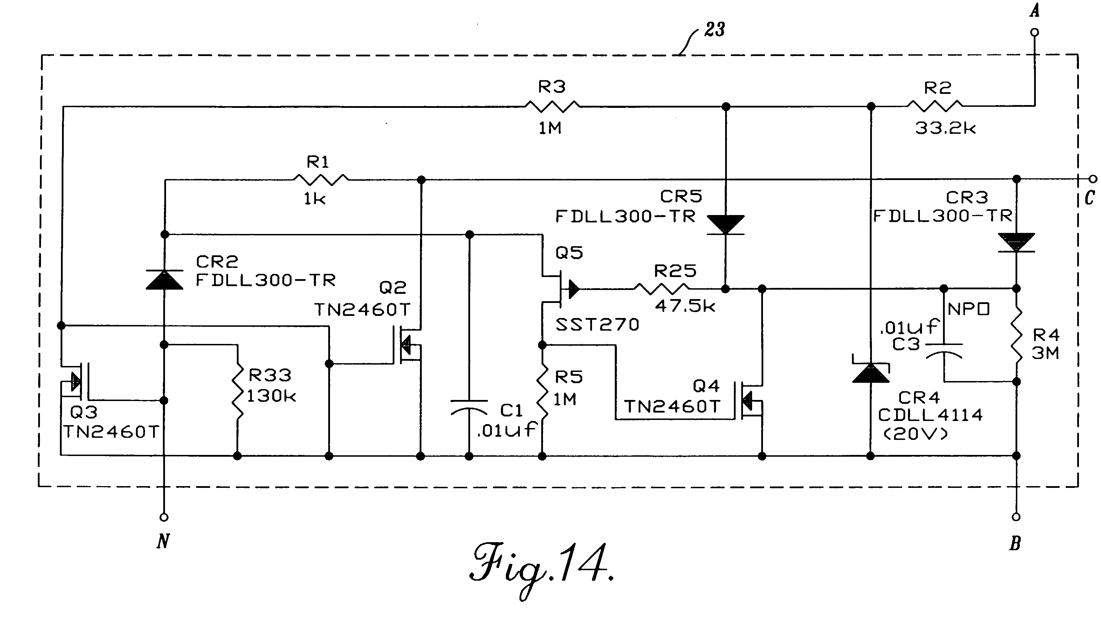

Charge transfer is conveyed through the on timer and current limit circuit 23, shown in detail in FIGURE 14. The path from line N is through diode CR2 and resistor R1 to the trigger input C of the main power switch. The result is that the main power MOSFET Q1 (FIGURE 4) is turned on and will remain in the on state until turned off.

It should be kept in mind that the entire power-up, pressure sensing, and switch controlling process occurs during a single pulse from the off timer, i.e., in approximately 1 millisecond in the preferred embodiment. Also, during this time power to the off timer, required for the remainder of the circuit operation, was obtained by virtue of the fact that the main power switch was off such that the voltage from the power source (V+) was applied across the switch. Once the switch has been turned on, power no longer is available for circuit operation. Consequently, the on timer 23 periodically drains the charge from the trigger input (C) of the main power switch, such as once every 32 milliseconds. In the off state of the main power switch, the timing capacitor C3 is charged. In the off state of the main power switch, capacitor C3 discharges "gradually," i.e., in about 32 milliseconds, which results in turning on transistors Q4 and Q5. Charge at C is immediately drained through CR3 and Q4, which momentarily opens the power switch to power up the voltage regulator, off timer, etc., for the periodic monitoring of the sensed condition. The off timer substantially immediately supplies the 1 millisecond 10-volt pulse for powering up the circuit components to evaluate the pressure and, if appropriate, substantially immediately transfer charge back to the trigger input of the main power switch to maintain it in its on or closed state.

The circuit of FIGURE 14 also has the effect of limiting maximum current applied across the main power switch. Desaturation of the main power switch Q1, in combination with increasing voltage across its series resistor R35, both caused by excess current, will have the effect of turning on transistor Q2 which quickly drains the charge from the gate (C) of the power switch, thereby turning off the power switch for excess current conditions.

Thus, the solid-state switch in accordance with the present invention periodically monitors the sensed condition and controls the flow of current from a source to a load, without requiring a separate power source for circuit operation and with minimal effect on the voltage available for the load. Consequently, the solid-state switch can replace a mechanical switch without extensive redesign of the system or circuit in which the switch is used.

While the preferred embodiment of the invention has been illustrated and described, it will be appreciated that various changes can be made therein without departing from the scope of the invention as defined in the claims.

## Claims

1. A switch (10) having two switching terminals (11 and 12) for automatically controlling the supply of power from a voltage source (V+), connected to one of said terminals, to a load (8), connected to the other of said terminals, based on an environmental condition to which the switch (10) is subjected comprising:
a solid-state switching component (14) coupled between said two terminals (11 and 12) which are connectable respectively to the voltage source (V+) and the load (8) and having a trigger input for actuation of the switching component (14) so as to selectively control the switching component (14) between an on state and an off state;
an off timer circuit (16) powered by the voltage source (V+), through a coupling to said two terminals (11 and 12) only, when the switching component (14) is its off state for periodically generating pulses of short duration with the period between consecutive pulses being much greater than the duration of each pulse;
a sensing circuit (17) for sensing the environmental condition and for generating a trigger signal pulse to the trigger input of the switching component (14) based on the condition sensed, such that the switching component (14) is actuated to its on and off states as a function of changes in the sensed condition; and
an on-timer circuit (23) powered by the voltage source (V+), through a coupling to said two terminals (11 and 12) only, when the switching component (14) is in its on state for periodically momentarily supplying an interrupt signal to the trigger input of the switching component (14) to actuate the switching component (14) to its off state if the switching component (14) was previously in its on state for powering the off timer circuit (16) to again supply the power pulses, whereby the environmental condition continues to be sensed periodically and the trigger signal continues to be generated periodically based on the sensed condition;
characterized by:
the pulses generated by the off timer circuit (16) being power pulses; and
the sensing circuit (17) being powered by the power pulses for sensing the environmental condition only during each power pulse, and for generating the trigger signal for each power pulse for application to the trigger input of the switching component (14) based on the condition sensed.

2. The switch (10) defined in Claim 1, further characterized by the sensing circuit (17) including a sensor (RA, RB, RC, RD, RE) for sensing the environmental condition during each power pulse, a first signal generator (19) for generating a signal varying based on the sensed condition, a reference signal generator (R22, R23) for generating a fixed signal during each power pulse and a comparator circuit (20) for comparing the first signal with the reference signal and for generating the trigger signal when a predetermined relationship exists between the reference signal and the first signal.

3. The switch (10) defined in Claim 2, further characterized by the sensing circuit (17) including a memory circuit (21) for adjusting the reference signal based on whether the switching component (14) was in its on or off state during the preceding power pulse.

4. The switch (10) defined in any preceding claim, further characterized by the switching component (14) including a power MOSFET(Q1), the sensing circuit (17) including means for actuating the power MOSFET (Q1) to its on state by supplying charge to the gate, the power MOSFET (Q1) normally being in its on state following supply of charge to its gate, and the trigger signal being effective to drain charge from the gate of the power MOSFET (Q1) for actuating the MOSFET (Q1) to its off state as a function of change in the sensed condition.

5. The switch (10) defined in any preceding claim, further characterized by the sensed condition being pressure.

6. The switch (10) defined in Claim 5, further characterized by the sensing circuit (17) including a pressure sensor (RA, RB, RC, RD, RE) providing, during each power pulse, a signal which is a function of the ambient temperature, the sensing circuit (17) further including a temperature compensation circuit (18) for adjusting the first signal for substantially uniform operation based on varying pressure for a wide temperature range.

7. The switch (10) defined in any preceding claim, further characterized by power to the switching component (14), off timer circuit (16), sensing circuit (17), and on timer circuit (23) being obtained solely by two-wire interconnection between the source (V+) and the load (8) such that the switch (10) emulates a mechanical switch without requiring independent power or substantially altering power available to the load (8).

8. The method of automatically controlling the supply of power from a voltage source (V+) to a load (8) based on an environmental condition which comprises connecting a solid-state switching component (14) between the voltage source (V+) and the load (8), such switching component (14) having a trigger input for actuation between an on state and off state; an off timer circuit (16) and an on-timer circuit (23) being powered by said voltage source through a coupling to the terminals of the switching component only
characterized by:
when the switching component (14) is off, periodically applying by said off timer circuit a power pulse of short duration with the period between consecutive power pulses being much greater than the duration of each pulse to a sensing circuit (17) for sensing the environmental condition only during each power pulse, such sensing circuit (17) including means (19, 20, 21, 22, 23) for generating a trigger signal to the switching component (14) such that the switching component (14) is actuated to its on and off states as a function of change in the sensed condition; and
when the switching component (14) is on, periodically momentarily actuating the switching component (14) to its off condition by said on-timer circuit for again supplying the periodic power pulses for monitoring the sensed condition.

## Patentansprüche

1. Schalter (10) mit zwei Schaltanschlüssen (11 und 12) zum automatischen Steuern der Spannungszufuhr von einer Spannungsquelle (V+), die an einem der Anschlüsse angeschlossen ist, zu einer Last (8), die an den anderen der Anschlüsse angeschlossen ist, basierend auf einer Umgebungsbedingung, welcher der Schalter (10) ausgesetzt ist, umfassend:
ein Festkörperschaltbauelement (14), welches zwischen die beiden Anschlüsse (11 und 12) gekoppelt ist, die mit der Spannungsquelle (V+) bzw. der Last (8) verbindbar sind, und mit einem Triggereingang zur Betätigung des Schaltbauelements (14), um dadurch selektiv das Schaltbauelement (14) zwischen einem Ein-Zustand und einem Aus-Zustand zu steuern;
eine Aus-Zeitsteuerschaltung (16), die von der Spannungsquelle (V+) über eine Kopplung an die zwei Anschlüsse (11 und 12) nur gespeist wird, wenn das Schaltbauelement (14) sich in seinem Aus-Zustand befindet, um periodisch Impulse kurzer Dauer zu erzeugen, wobei die Zeitspanne zwischen aufeinanderfolgenden Impulsen größer ist als die Dauer jedes Impulses;
eine Fühlschaltung (17) zum Fühlen der Umgebungsbedingung und zum Erzeugen eines Triggersignalimpulses zum Triggern des Eingangs des Schaltbauelements (14) basierend auf der gefühlten Bedingung, so daß das Schaltbauelement (14) als Funktion von Änderungen der gefühlten Bedingung in seinen Ein- und seinen Aus-Zustand gebracht wird; und
eine Ein-Zeitsteuerschaltung (23), die von der Spannungsquelle (V+) über eine Kopplung an die beiden Anschlüsse (11 und 12) nur gespeist wird, wenn das Schaltbauelement (14) sich in seinem Ein-Zustand befindet, um periodisch und vorübergehend ein Unterbrechungssignal an den Triggereingang des Schaltbauelements (14) zu liefern und dadurch das Schaltbauelement (14) in seinen Aus-Zustand zu bringen, falls das Schaltbauelement (14) zuvor in seinem Ein-Zustand war, um die Aus-Zeitsteuerschaltung (16) zu speisen, damit sie erneut Leistungsimpulse liefert, wodurch die Umgebungsbedingung weiter periodisch abgefühlt wird und das Triggersignal basierend auf der gefühlten Bedingung periodisch weitererzeugt wird;
**dadurch gekennzeichnet, daß**
die von der Aus-Zeitsteuerschaltung (16) erzeugten Impulse Leistungsimpulse sind; und
die Fühlschaltung (17) von den Leistungsimpulsen gespeist wird, um die Umgebungsbedingung nur während jedes Leistungsimpulses zu fühlen, und um das Triggersignal für jeden Leistungsimpuls zum Anlegen an den Triggereingang des Schaltbauelements (14) basierend auf der gefühlten Bedingung zu erzeugen.

2. Schalter (10) nach Anspruch 1, **dadurch gekennzeichnet, daß** die Fühlschaltung (17) einen Fühler (RH, RB, RC, RD, RE) zum Fühlen der Umgebungsbedingung während jedes Leistungsimpulses enthält, ferner einen ersten Signalgenerator (19) zum Erzeugen eines Signals, welches aufgrund der gefühlten Bedingung variiert, einen Referenzsignalgeber (R22, R23) zum Erzeugen eines festen Signals während jedes Leistungsimpulses, und eine Vergleicherschaltung (20) zum Vergleichen des ersten Signals mit dem Referenzsignal und zum Erzeugen des Triggersignals, wenn zwischen dem Referenzsignal und dem ersten Signal eine vorbestimmte Beziehung herrscht.

3. Schalter (10) nach Anspruch 2, **dadurch gekennzeichnet, daß** die Fühlschaltung (17) eine Speicherschaltung (21) zum Justieren des Referenzsignals enthält, basierend darauf, ob das Schaltbauelement (14) sich während des vorausgehenden Leistungsimpulses in seinem Ein- oder in seinem Aus-Zustand befunden hat.

4. Schalter (10) nach einem vorhergehenden Anspruch, **dadurch gekennzeichnet, daß** das Schaltbauelement (14) einen Leistungs-MOSFET (Q1) aufweist, die Fühlschaltung (17) eine Einrichtung zum Aktivieren des Leistungs-MOSFETs (Q1) in seinem Ein-Zustand durch Zuführen einer Ladung zu dem Gate aufweist, wobei der Leistungs-MOSFET (Q1) sich normalerweise in seinem Ein-Zustand befindet, nachdem seinem Gate Ladung zugeführt wurde, und das Triggersignal die Wirkung hat, Ladung von dem Gate des Leistungs-MOSFETs (Q1) zum Aktivieren des MOSFETs (Q1) abzuleiten, damit dieser als Funktion der Änderung der gefühlten Bedingung in seinen Aus-Zustand gelangt.

5. Schalter (10) nach einem vorhergehenden Anspruch, außerdem **dadurch gekennzeichnet, daß** der gefühlte Zustand Druck ist.

6. Schalter (10) nach Anspruch 5, **dadurch gekennzeichnet, daß** die Fühlschaltung (17) einen Drucksensor (RA, RB, RC, RD, RE) enthält, der während jedes Leistungsimpulses ein Signal liefert, welches eine Funktion der Umgebungstemperatur ist, die Fühlschaltung (17) außerdem eine Temperaturkompensationsschaltung (18) aufweist, um das erste Signal für einen im wesentlichen gleichmäßigen Betrieb basierend auf sich änderndem Druck in einem breiten Temperaturbereich einzustellen.

7. Schalter (10) nach einem vorhergehenden Anspruch, **dadurch gekennzeichnet, daß** die Stromversorgung für das Schaltbauelement (14), die Aus-Zeitsteuerschaltung (16), die Fühlschaltung (17) und die Ein-Zeitsteuerschaltung (23) ausschließlich über eine Zweidrahtverbindung zwischen der Quelle (V+) und der Last (8) erfolgt, so daß der Schalter (10) einen mechanischen Schalter emuliert, ohne daß unabhängige Leistung erforderlich wäre oder die für die Last (8) verfügbare Leistung nennenswert geändert werden müßte.

8. Verfahren zum automatischen Steuern der Stromzufuhr von einer Spannungsquelle (V+) zu einer Last (8) basierend auf einer Umgebungsbedingung, umfassend das Verbinden eines Festkörperschaltbauelements (14) zwischen der Spannungsquelle (V+) und der Last (8), wobei dieses Schaltbauelement (14) einen Triggereingang zur Aktivierung zwischen Ein-Zustand und Aus-Zustand besitzt; wobei eine Aus-Zeitsteuerschaltung (16) und eine Ein-Zeitsteuerschaltung (23) von der Spannungsquelle gespeist werden, indem lediglich die Anschlüsse des Schaltbauelements gekoppelt werden,
**dadurch gekennzeichnet**, daß, wenn das Schaltbauelement (14) ausgeschaltet ist, periodisch von der Aus-Zeitsteuerschaltung ein Leistungsimpuls kurzer Dauer mit einer Impulspause zwischen aufeinanderfolgenden Leistungsimpulsen, die viel größer ist als die Dauer jedes Impulses, an eine Fühlschaltung (17) zum Fühlen der Umgebungsbedingung nur während jedes Leistungsimpulses gegeben wird, wobei diese Fühlschaltung (17) eine Einrichtung (19, 20, 21, 22, 23) aufweist, um für das Schaltbauelement (14) ein Triggersignal zu generieren, so daß das Schaltbauelement (14) als Funktion einer Änderung der gefühlten Bedingung in seinen Ein- und seinen Aus-Zustand gebracht wird; und
wobei dann, wenn das Schaltbauelement (14) eingeschaltet ist, dieses Schaltbauelement (14) periodisch und vorübergehend von der Ein-Zeitsteuerschaltung in seinen Aus-Zustand gebracht wird, um die periodischen Leistungsimpulse erneut zuzuführen zwecks Überwachung der gefühlten Bedingung.

## Revendications

1. Interrupteur (10) ayant deux bornes (11 et 12) de commutation pour commander automatiquement la fourniture d'une puissance provenant d'une source (V+) de tension reliée à l'une desdites bornes, à une charge (8) reliée à l'autre desdites bornes, en se basant sur une condition d'environnement à laquelle est soumis l'interrupteur (10), comprenant :
un composant semi-conducteur (14) de commutation couplé entre lesdites deux bornes (11 et 12) qui peuvent être raccordées respectivement à la source (V+) de tension et à la charge (8) et ayant une entrée de déclenchement pour actionner le composant (14) de commutation de manière à commander sélectivement le composant (14) de commutation entre un état passant et un état bloqué ;
un circuit (16) de minuterie de désactivation alimenté par la source (V+) de tension au moyen d'un couplage auxdites deux bornes (11 et 12) seulement quand le composant (14) de commutation est dans son état bloqué pour produire périodiquement des impulsions de courte durée, la période entre des impulsions consécutives étant très supérieure à la durée de chaque impulsion ;
un circuit (17) de détection pour détecter la condition d'environnement et pour produire une impulsion de signal de déclenchement appliquée à l'entrée de déclenchement du composant (14) de commutation en se basant sur la condition détectée, de sorte que le composant (14) de commutation soit actionné pour prendre ses états passant et bloqué en fonction de variations de la condition détectée ; et
un circuit (23) de minuterie d'activation alimenté par la source (V+) de tension au moyen d'un couplage auxdites deux bornes (11 et 12) seulement quand le composant (14) de commutation est dans son état passant pour fournir périodiquement de manière momentanée un signal d'interruption à l'entrée de déclenchement du composant (14) de commutation afin de faire passer le composant (14) de commutation à son état bloqué si le composant (14) de commutation était précédemment à son état passant pour alimenter le circuit (16) de minuterie de désactivation afin de fournir de nouveau les impulsions de puissance, de sorte que la condition d'environnement continue à être détectée périodiquement et que le signal de déclenchement continue à être produit périodiquement en se basant sur la condition détectée ;
caractérisé en ce que :
les impulsions produites par le circuit (16) de minuterie de désactivation sont des impulsions de puissance ; et
le circuit (17) de détection est alimenté par les impulsions de puissance pour détecter la condition d'environnement seulement pendant chaque impulsion de puissance, et pour produire le signal de déclenchement pour chaque impulsion de puissance en vue d'une application à l'entrée de déclenchement du composant (14) de commutation en se basant sur la condition détectée.

2. Interrupteur (10) selon la revendication 1, caractérisé en outre en ce que le circuit (17) de détection comprend un capteur (RA, RB, RC, RD, RE) pour détecter la condition d'environnement pendant chaque impulsion de puissance, un premier générateur (19) de signal pour produire un signal variant en fonction de la condition détectée, un générateur (R22, R23) de signal de référence pour produire un signal fixe pendant chaque impulsion de puissance, et un circuit comparateur (20) pour comparer le premier signal au signal de référence et pour produire le signal de déclenchement quand une relation prédéterminée existe entre le signal de référence et le premier signal.

3. Interrupteur (10) selon la revendication 2, caractérisé en outre en ce que le circuit (17) de détection comprend un circuit (21) de mémoire pour ajuster le signal de référence en se basant sur le fait que le composant (14) de commutation était dans son état passant ou bloqué pendant l'impulsion précédente de puissance.

4. Interrupteur (10) selon l'une quelconque des revendications précédentes, caractérisé en outre en ce que le composant (14) de commutation comprend un transistor MOSFET (Q1) de puissance, le circuit (17) de détection comprend des moyens pour faire passer le transistor MOSFET (Q1) de puissance à son état passant en fournissant une charge à sa grille, le transistor MOSFET (Q1) de puissance étant normalement à son état passant après la fourniture d'une charge sur sa grille, et le signal de déclenchement servant à extraire une charge de la grille du transistor MOSFET (Q1) de puissance de manière à faire passer le transistor MOSFET (Q1) de puissance à son état bloqué en fonction d'une variation de la condition détectée.

5. Interrupteur (10) selon l'une quelconque des revendications précédentes, caractérisé en outre en ce que la condition détectée est une pression.

6. Interrupteur (10) selon la revendication 5, caractérisé en outre en ce que le circuit (17) de détection comprend un capteur (RA, RB, RC, RD, RE) de pression fournissant, pendant chaque impulsion de puissance, un signal qui est une fonction de la température ambiante, le circuit (17) de détection comprenant en outre un circuit (18) de compensation de température pour ajuster le premier signal afin d'obtenir un fonctionnement pratiquement uniforme en se basant sur une variation de pression dans une gamme étendue de températures.

7. Interrupteur (10) selon l'une quelconque des revendications précédentes, caractérisé en outre en ce que l'alimentation du composant (14) de commutation, du circuit (16) de minuterie de désactivation, du circuit (17) de détection et du circuit (23) de minuterie d'activation est obtenue seulement par une interconnexion en deux fils entre la source (V+) et la charge (8), de sorte que l'interrupteur (10) émule un interrupteur mécanique sans nécessiter une alimentation indépendante ni modifier sensiblement la puissance disponible pour la charge (8).

8. Procédé pour commander automatiquement la fourniture d'une puissance provenant d'une source (V+) de tension à une charge (8) en se basant sur une condition d'environnement, qui comprend de relier un composant semi-conducteur (14) de commutation entre la source (V+) de tension et la charge (8), un tel composant (14) de commutation ayant une entrée de déclenchement pour provoquer un passage entre un état passant et un état bloqué ;
un circuit (16) de minuterie de désactivation et circuit (23) de minuterie d'activation étant alimentés par ladite source de tension au moyen d'un couplage aux bornes du composant de commutation seulement ;
caractérisé en ce que :
quand le composant (14) de commutation est bloqué, ledit circuit de minuterie de désactivation applique périodiquement une impulsion de puissance, dont la période entre des impulsions consécutives de puissance est très supérieure à la durée de chaque impulsion, à un circuit (17) de détection pour détecter la condition d'environnement seulement pendant chaque impulsion de puissance, un tel circuit (17) de détection comprenant des moyens (19, 20, 21, 22, 23) pour produire un signal de déclenchement appliqué au composant (14) de commutation de sorte que le composant (14) de commutation soit actionné pour passer à ses état passant et bloqué en fonction d'une variation de la condition détectée ; et
quand le composant (14) de commutation est passant, le composant (14) de commutation est actionné momentanément et d'une manière périodique pour passer à sa condition bloquée par ledit circuit de minuterie d'activation afin de fournir de nouveau les impulsions périodiques de puissance pour surveiller la condition détectée.
